# EUROPÄISCHE PATENTSCHRIFT

(11) **EP 3 061 321 B1**
(45) Veröffentlichungstag und Bekanntmachung des Hinweises auf die Patenterteilung: **07.06.2023**
(21) Anmeldenummer: 14786677.6
(22) Anmeldetag: 21.10.2014
(51) Int. Cl.: H05B 45/20

(54) **MELANOPISCHE LEUCHTE**
LAMP WHICH INFLUENCES THE MELANOPSIN PRODUCTION
APPAREIL D'ÉCLAIRAGE MÉLANOPIQUE

(30) Priorität: 25.10.2013 DE 102013221723
(43) Veröffentlichungstag der Anmeldung: 31.08.2016
(73) Patentinhaber: Zumtobel Lighting GmbH, 6850 Dornbirn (AT)
(72) Erfinder: FROHNAPFEL, Anja, 6850 Dornbirn (AT); TRALAU, Birthe, 6850 Dornbirn (AT)
(74) Vertreter: Thun, Clemens
(86) Internationale Anmeldenummer: PCT/EP2014/072538
(87) Internationale Veröffentlichungsnummer: WO 2015/059136

(56) Entgegenhaltungen:
- EP-A2- 1 160 883
- WO-A1-01/41215
- WO-A1-2010/003763
- DE-A1-102008 025 864
- DE-A1-102010 030 061
- DE-A1-102010 039 308
- US-A1- 2012 206 050
- US-A1- 2014 184 088
- US-B2- 8 339 029
- DIETRICH ; GALL ET AL: "Gall DEFINITION AND MEASUREMENT OF CIRCADIAN RADIOMETRIC QUANTITIES", ILMEDIA, 2 October 2004 (2004-10-02), pages 129-132, XP055636770, ISBN: 978-3-901906-37-4

## Beschreibung

Die Erfindung betrifft eine Leuchte mit einer erste Lichtquelle zur Erzeugung eines ersten Lichts und einer zweiten Lichtquelle zur Erzeugung eines zweiten Lichts, sowie mit einer Steuereinheit zur Ansteuerung der ersten Lichtquelle und der zweiten Lichtquelle, die derart gestaltet ist, dass eine Intensität des ersten Lichts unabhängig von einer Intensität des zweiten Lichts verändert werden kann.

Aus dem Stand der Technik ist eine solche Leuchte bekannt, bei der sich mit der ersten Lichtquelle ein warmweißes Licht erzeugen lässt und mit der zweiten Lichtquelle ein kaltweißes Licht. Die Farbtemperatur von warmweißem Licht (z. B. 3000 K) ist niedriger als die Farbtemperatur von kaltweißem Licht (z. B. 7000 K). Somit lassen sich durch die Steuereinheit die beiden Lichtquellen so ansteuern, dass sich die Farbtemperatur des insgesamt von der Leuchte abgegebenen Lichts innerhalb bestimmter Grenzen verstellen bzw. einstellen lässt.

Bekanntlich ist Licht für einen menschlichen Betrachter nicht nur von Bedeutung mit Bezug auf das Sehen, sondern es hat im Allgemeinen auch eine darüber hinausgehende biologische Wirkung, die das circadiane Verhalten des Betrachters betrifft. Bei der genannten Leuchte ist diese zuletzt genannte biologische Wirkungskomponente des Lichts grundsätzlich von der Farbtemperatur des Lichts abhängig. Die entsprechende Wirkung von kaltweißem Licht ist - bei ansonsten gleichen Bedingungen - höher als diejenige von warmweißem Licht. Grund hierfür ist, dass das kaltweiße Licht einen höheren Anteil an blauem Licht aufweist als das warmweiße Licht.

Zur Beschreibung der genannten biologischen Wirkungskomponente lässt sich der so genannte circadiane Wirkungsfaktor *A_{cv}* verwenden, der das Verhältnis von der circadianen Wirkung eines Lichts zu der visuellen Wirkung dieses Lichts angibt. Für die circadiane Wirkung spielen Rezeptoren im menschlichen Auge eine Rolle, die das Protein Melanopsin enthalten und in signifikanter Weise Einfluss auf den zeitlichen Verlauf der Ausschüttung des Hormons Melatonin nehmen. Daher wird der circadiane Wirkungsfaktor auch als melanopischer Wirkungsfaktor bezeichnet.

Mit der bekannten Leuchte lässt sich also durch gegenläufiges Verändern der Intensitäten des warmweißen Lichts und des kaltweißen Lichts der melanopische bzw. circadiane Wirkungsfaktor des von der Leuchte abgegebene Lichts verändern bzw. verstellen. Allerdings geht dies - bei ansonsten gleichbleibenden Bedingungen - mit einer Veränderung der Farbtemperatur des Lichts einher.

Aus der DE 10 2008 025 864 A1 ist ein LED Modul mit zwei Lumineszenz-Konversions-LEDs unterschiedlicher Lichtfarbe bekannt. Die Intensität der einzelnen Lichtfarben ist durch eine getrennte Ansteuerung einstellbar.

Aus der DE 10 2010 039 308 A1 ist eine Beleuchtungsanordnung mit verschiedenfarbigen Lichtquellen bekannt. Die Beleuchtungsanordnung eignet sich insbesondere zur Beleuchtung von Lebensmitteln. Dabei lässt sich in einem ersten Schritt Licht eines gewünschten Farborts wählen und in einem zweiten Schritt eine geeignete spektrale Zusammensetzung für die Lichtabgabe.

Aus der DE 10 2010 030 061 A1 ist eine Farbregelvorrichtung für eine LED-Leuchtvorrichtung bekannt. Dabei werden die LEDs so geregelt, dass sich eine Lichtabgabe ergibt, deren Farbort sich innerhalb einer MacAdam-Ellipse bewegt.

Die US 8,339,029 B2 zeigt eine Leuchte mit zwei Leuchtmitteln unterschiedlicher Farbtemperatur. Die beiden Leuchtmittel weisen jeweils eine Farbtemperatur auf, welche jeweils innerhalb einer unterschiedlichen die Farbtemperatur definierenden 7-Schritt-Mc-Adam-Elipse liegt. Durch unterschiedliche Ansteuerung der beiden Leuchtmittel kann eine Einstellung einer gewünschten Farbtemperatur erreicht werden.

Der Erfindung liegt die Aufgabe zugrunde, eine entsprechende verbesserte Leuchte anzugeben; insbesondere soll sich die Leuchte dazu eignen, den circadianen bzw. melanopische Wirkungsfaktor des abgegebenen Lichts bei gleichbleibender Farbtemperatur des Lichts zu verändern.

Diese Aufgabe wird gemäß der Erfindung mit dem in dem unabhängigen Anspruch genannten Gegenstand gelöst. Besondere Ausführungsarten der Erfindung sind in den abhängigen Ansprüchen angegeben. Abschnitte der folgenden Beschreibung, welche sich auf Ausführungsbeispiele beziehen, die nicht von den Ansprüchen abgedeckt sind, sollen nicht als Ausführungsbeispiele, sondern als zum Verständnis der Erfindung hilfreiche Beispiele verstanden werden.

Gemäß der Erfindung ist eine Leuchte vorgesehen, die eine erste Lichtquelle zur Erzeugung eines ersten Lichts mit einer ersten Spektralverteilung aufweist, wobei das erste Licht durch einen ersten Farbort in einem Farbdiagramm repräsentiert ist, sowie eine zweite Lichtquelle zur Erzeugung eines zweiten Lichts mit einer zweiten Spektralverteilung, wobei das zweite Licht durch einen zweiten Farbort in dem Farbdiagramm repräsentiert ist; dabei unterscheidet sich die zweite Spektralverteilung von der ersten Spektralverteilung. Weiterhin weist die Leuchte eine Steuereinheit zur Ansteuerung der ersten Lichtquelle und der zweiten Lichtquelle auf, die derart gestaltet ist, dass eine Intensität des ersten Lichts unabhängig von einer Intensität des zweiten Lichts verändert werden kann. Die Leuchte ist dabei derart gestaltet, dass der erste Farbort im Wesentlichen mit dem zweiten Farbort übereinstimmt.

Mit anderen Worten ist die Leuchte so gestaltet, dass es sich bei der ersten Lichtquelle und der zweiten Lichtquelle um metamere Lichtquellen handelt.

Auf diese Weise lässt sich erzielen, dass durch ein Verändern der Intensitäten des ersten und des zweiten Lichts die Gewichtung der beiden Lichter so verändert werden kann, dass sich dadurch der melanopische Wirkungsfaktor des von der Leuchte insgesamt abgegeben Lichts verändert, ohne dass sich dabei die Farbtemperatur dieses Lichts verändert. Dabei lässt sich grundsätzlich auch erzielen, dass die Gesamtintensität, zusammengesetzt aus der Intensität des ersten Lichts und des zweiten Lichts, bei einer Veränderung des melanopischen Wirkungsfaktors konstant bleibt.

Erfindungsgemäß sind dabei der erste Farbort und der zweite Farbort innerhalb einer Sieben-Schritt-MacAdam-Ellipse lokalisiert, besonders bevorzugt innerhalb einer Drei-Schritt-MacAdam-Ellipse. Auf diese Weise lässt sich der Farbeindruck des von der Leuchte insgesamt abgegebenen Lichts bei einer Veränderung des melanopischen Wirkungsfaktors besonders geeignet praktisch konstant halten.

Vorzugsweise entspricht der erste Farbort einer ersten Farbtemperatur und der zweite Farbort einer zweiten Farbtemperatur, wobei sich die erste Farbtemperatur um weniger als 500 K von der der zweiten Farbtemperatur unterscheidet. Auf diese Weise lässt sich mit der Leuchte ein geeignetes Weißlicht erzeugen. Eine besonders gute Konstanz des Farbeindrucks des Lichts bei Veränderung des melanopischen Wirkungsfaktors lässt sich erzielen, wenn sich dabei die erste Farbtemperatur um weniger als 300 K von der der zweiten Farbtemperatur unterscheidet, besonders bevorzugt um weniger als 100 K.

Ein besonders geeignetes Licht lässt sich erzielen, wenn die erste Farbtemperatur und die zweite Farbtemperatur zwischen 2000 K und 7000 K betragen, vorzugsweise zwischen 3000 K und 6000 K. Beispielsweise kann etwa 4000 K vorgesehen sein, dies entspricht einem neutralen Weiß.

Vorzugsweise ist die Leuchte derart gestaltet, dass das erste Licht einen ersten circadianen Wirkungsfaktor aufweist und das zweite Licht einen zweiten circadianen Wirkungsfaktor, derart, dass sich der erste circadiane Wirkungsfaktor von dem zweiten circadianen Wirkungsfaktor um mehr als 0,10, vorzugsweise um mehr als 0,20, besonders bevorzugt um mehr als 0,30 unterscheidet. Auf diese Weise lässt sich die circadiane Wirkung der Leuchte besonders wirkungsvoll verstellen.

Vorzugsweise ist die erste Lichtquelle eine erste LED-Lichtquelle und die zweite Lichtquelle eine zweite LED-Lichtquelle. Dies ist sowohl herstellungstechnisch als auch mit Bezug auf die Effizienz der Leuchte vorteilhaft.

Vorzugsweise umfasst die erste Lichtquelle wenigstens eine LED zur Erzeugung eines roten Lichts und wenigstens eine LED zur Erzeugung eines weißen Lichts. Auf diese Weise lässt sich eine besonders effiziente Erzeugung des ersten Lichts bewirken.

Vorzugsweise weist das erste Licht einen höheren Farbwiedergabeindex auf als das zweite Licht.

Vorzugsweise weist die Leuchte weiterhin einen Lichtaustrittsbereich zum Durchtritt des ersten Lichts und des zweiten Lichts auf. Hierdurch lässt sich eine besonders geeignete Überlagerung bzw. Mischung des ersten Lichts mit dem zweiten Licht erzielen.

Vorzugsweise ist die Leuchte dabei derart gestaltet, dass eine Größe des Lichtaustrittsbereichs veränderbar ist. Durch eine Veränderung des Lichtaustrittsbereichs lässt sich - bei ansonsten unveränderten Bedingungen - die melanopische Wirkung des Lichts verändern: Durch eine Vergrößerung des Lichtaustrittsbereichs lässt sich grundsätzlich die melanopische Wirkung intensivieren. Vorzugsweise ist dabei die Größe des Lichtaustrittsbereichs wenigstens um einen Faktor 2 veränderbar, besonders vorteilhaft wenigstens um einen Faktor 4, insbesondere wenigstens um einen Faktor 10.

Die Erfindung wird im Folgenden anhand eines Ausführungsbeispiels und mit Bezug auf die Zeichnungen näher erläutert. Es zeigen:
- Fig. 1: eine schematische Prinzip-Skizze eines Ausführungsbeispiels einer erfindungsgemäßen Leuchte,
- Fig. 2a: ein Beispiel einer ersten Spektralverteilung eines ersten Lichts der Leuchte,
- Fig. 2b: ein Beispiel einer zweiten Spektralverteilung eines zweiten Lichts der Leuchte,
- Fig. 3: eine schematische Prinzip-Skizze zu einer Ausführung der Leuchte mit einem in der Größe veränderbaren Lichtaustrittsbereich und
- Fig. 4: eine schematische Prinzip-Skizze zu einer Ausführung der Leuchte, bei der sich die melanopische Wirkung über einen Drehschalter, der an der Leuchte angeordnet ist, verstellen lässt.

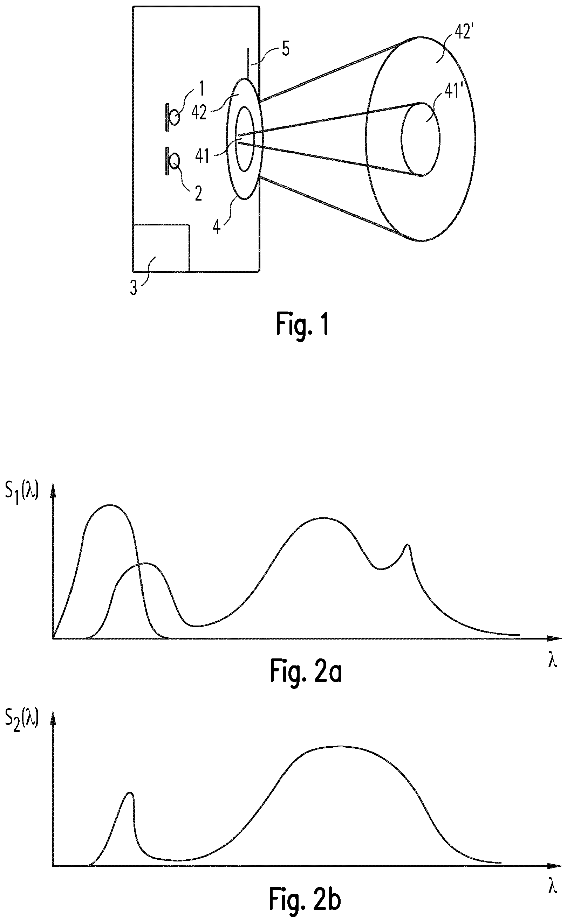

Fig. 1 zeigt eine sehr schematische Prinzip-Skizze eines Ausführungsbeispiels einer erfindungsgemäßen Leuchte im Sinn einer Querschnitt-Darstellung. Die Leuchte weist eine erste Lichtquelle 1 zur Erzeugung eines ersten Lichts mit einer ersten Spektralverteilung auf, die exemplarisch in Fig. 2a als Verteilung *S₁(λ)* in Abhängigkeit der Wellenlänge *λ* skizziert ist. Dabei ist das erste Licht durch einen ersten Farbort *F1* in einem Farbdiagramm repräsentiert, beispielsweise in der bekannten CIE-Normfarbtafel aus dem Jahr 1931.

Weiterhin weist die Leuchte eine zweite Lichtquelle 2 zur Erzeugung eines zweiten Lichts mit einer zweiten Spektralverteilung auf, die exemplarisch in Fig. 2b als Verteilung *S₂(λ)* in Abhängigkeit der Wellenlänge *λ* skizziert ist. Dabei ist das zweite Licht durch einen zweiten Farbort *F2* in dem Farbdiagramm repräsentiert.

Die zweite Spektralverteilung *S₂(λ)* unterscheidet sich dabei von der ersten Spektralverteilung *S₁(λ),* wie aus den Skizzen der Figuren 2a und 2b beispielhaft hervorgeht.

Es kann vorgesehen sein, dass die Leuchte neben der ersten Lichtquelle 1 und der zweiten Lichtquelle 2 keine weitere Lichtquelle aufweist. Insbesondere kann vorgesehen sein, dass sich das insgesamt von der Leuchte abgegebene Licht lediglich aus dem ersten Licht und dem zweiten Licht zusammensetzt.

Vorzugsweise ist die Leuchte so gestaltet, dass das erste Licht und das zweite Licht in sich gegenseitig überlagernder Weise abgegeben werden, also das von der Leuchte insgesamt abgegebene Licht durch eine Mischung des ersten Lichts mit dem zweiten Licht gebildet ist.

Weiterhin weist die Leuchte eine Steuereinheit 3 zur Ansteuerung der ersten Lichtquelle 1 und der zweiten Lichtquelle 2 auf, die derart gestaltet ist, dass eine Intensität des ersten Lichts unabhängig von einer Intensität des zweiten Lichts verändert werden kann.

Die Leuchte ist dabei derart gestaltet, dass der erste Farbort *F1* zumindest im Wesentlichen mit dem zweiten Farbort *F2* übereinstimmt.

Auf diese Weise lässt sich erzielen, dass mit der Steuereinheit 3 die Intensitäten des ersten Lichts und des zweiten Lichts so verändert bzw. verstellt werden können, dass sich der melanopische bzw. circadiane Wirkungsfaktor des insgesamt von der Leuchte abgegebenen Lichts verändert, aber der Farbort dabei gleichbleibt. Es kann also die melanopische Wirksamkeit verstellt werden, ohne dass sich der Farbeindruck des abgegebenen Lichts dabei ändert. Dabei ist es durch entsprechendes gegenläufiges Verändern der beiden genannten Intensitäten möglich, die melanopische Wirkung des von der Leuchte abgegebenen Lichts zu verändern bzw. zu verstellen, ohne dass sich hierbei die Intensität des insgesamt von der Leuchte abgegebenen Lichts verändert. Hierzu ist die Steuereinheit ausgelegt die Intensität des ersten Lichts zu reduzieren und gleichzeitig die Intensität des zweiten Lichts zu erhöhen.

Die Gestaltung ist derart, dass der erste Farbort *F1* und der zweite Farbort *F2* innerhalb einer Sieben-Schritt-MacAdam-Ellipse lokalisiert sind, vorzugsweise innerhalb einer Drei-Schritt-MacAdam-Ellipse. Eine MacAdam-Ellipse um einen Bezugs-Farbort in der CIE-Normfarbtafel von 1931 gibt bekanntlich denjenigen Bereich von Farborten an, die von einem "durchschnittlichen" menschlichen Betrachter - unter bestimmten Bedingungen - nicht von dem Bezugs-Farbort unterschieden werden können. Dabei gilt, dass die Farbwahrnehmung von Mensch zu Mensch unterschiedlich ist, so dass eine MacAdam-Ellipse im Einzelfall immer nur eine näherungsweise Aussage zulässt.

Zur Angabe eines Abstands eines Farborts von einem Bezugs-Farbort lassen sich "Schritte" von MacAdam-Ellipsen angeben; die Anzahl der Schritte entspricht dabei einer Anzahl von Standardabweichungen -je größer die Anzahl der Schritte, desto größer die entsprechende Ellipse und desto mehr kann dementsprechend ein Farbort von dem Bezugs-Farbort abweichen. Innerhalb einer Ein-Schritt-MacAdam-Ellipse lässt sich praktisch von keinem Menschen ein Farbunterschied feststellen. Bei einer Vier-Schritt-MacAdam-Ellipse ist ein Farbunterschied für viele Menschen gerade wahrnehmbar. Innerhalb einer Sieben-Schritt-MacAdam-Ellipse lässt sich ein Farbunterschied für die meisten Menschen erkennen.

Vorzugsweise kann der erste Farbort *F1* einer ersten Farbtemperatur *CCT₁* entsprechen und der zweite Farbort *F2* einer zweiten Farbtemperatur *CCT₂,* wobei sich die erste Farbtemperatur *CCT₁* um weniger als 500 K von der der zweiten Farbtemperatur *CCT₂* unterscheidet, vorzugsweise um weniger als 300 K, besonders bevorzugt um weniger als 100 K. Auf diese Weise kann mit der Leuchte Weißlicht erzeugt werden.

Wenn die erste Farbtemperatur *CCT₁* und die zweite Farbtemperatur *CCT₂* zwischen 2000 K und 7000 K betragen, lässt sich eine Lichtabgabe in einem bevorzugten Weißton erzielen. Vorzugsweise beträgt die Farbtemperatur zwischen 3000 K und 6000 K. Ein "neutraler" Weißton lässt sich beispielsweise erzielen, wenn die erste bzw. zweite Farbtemperatur *CCT₁* bzw. *CCT₂* etwa 4000 K beträgt, also beispielsweise zwischen 3500 K und 4500 K. (Eine Abweichung von 100 K entspricht in diesem Fall ungefähr einer Vier-Schritt-MacAdam-Ellipse).

Vorzugsweise ist die Leuchte derart gestaltet, dass das erste Licht einen ersten circadianen Wirkungsfaktor *A_{cν1}* aufweist und das zweite Licht einen zweiten circadianen Wirkungsfaktor *A_{cν2}*, derart, dass sich der erste circadiane Wirkungsfaktor *A_{cν1}* von dem zweiten circadianen Wirkungsfaktor *A_{cν2}* um mehr als 0,10, vorzugsweise um mehr als 0,20, besonders bevorzugt um mehr als 0,30 unterscheidet. Je mehr sich der circadiane Wirkungsfaktor verstellen lässt, umso mehr kann die Wirkung des Lichts mit Bezug auf den circadianen Einfluss auf einen Betrachter verändert werden. Die Gestaltung kann durchaus auch so sein, dass sich der circadiane bzw. melanopische Wirkungsfaktor um mehr als 1,0 verstellen lässt.

Vorzugsweise ist die erste Lichtquelle 1 eine erste LED-Lichtquelle und die zweite Lichtquelle 2 eine zweite LED-Lichtquelle. Dies ist herstellungstechnisch und mit Bezug auf die Effizienz der Leuchte von Vorteil.

Beispielsweise kann die erste Lichtquelle 1 wenigstens eine LED zur Erzeugung eines roten Lichts und wenigstens eine LED zur Erzeugung eines weißen Lichts umfassen. Bei der LED zu Erzeugung eines weißen Lichts kann es sich beispielsweise um eine blaue LED mit einem Phosphor handeln, wie sie an sich bekannt ist und beispielsweise in der Schrift DE 10 2007 043 355 A1 beschrieben ist. Die Verwendung einer solchen LED ermöglicht eine besonders effiziente Lichtabgabe.

Das von der ersten Lichtquelle 1 erzeugte erste Licht kann einen höheren Farbwiedergabeindex aufweisen als das von der zweiten Lichtquelle 2 erzeugte zweite Licht.

Weiterhin vorzugsweise weist die Leuchte einen Lichtaustrittsbereich 4 zum Durchtritt des ersten Lichts und des zweiten Lichts auf, wie in Fig. 1 andeutungsweise skizziert. Dabei ist die Leuchte vorzugsweise derart gestaltet, dass eine Größe des Lichtaustrittsbereichs 4 veränderbar ist. Beispielsweise kann die Leuchte hierfür eine Blende 5 aufweisen, mit der die Größe des Lichtaustrittsbereichs 4 verstellt werden kann, insbesondere stufenlos verstellt werden kann. Es kann beispielsweise eine mechanische Verstellmöglichkeit der Größe vorgesehen sein und/oder eine Optik zur Verstellung der Größe mit einer Ansteuerung.

In Fig. 1 ist eine erste Größe 41 der Lichtaustrittfläche und eine zweite Größe 42 der Lichtaustrittsfläche 4 leicht perspektivisch angedeutet gezeigt, sowie ein erster beleuchteter Bereich 41', beispielsweise einer Wand oder eines Bodens eines Raumes bei Einstellung der ersten Größe 41 und - alternativ hierzu - ein entsprechend größerer zweiter beleuchteter Bereich 42' bei Einstellung der zweiten Größe 42.

Für die melanopische Wirkung des Lichts ist neben der Spektralverteilung wesentlich, wie groß die Areale der beiden entsprechenden beleuchteten Netzhautbereiche des Betrachters sind und auch, um welche Areale innerhalb der jeweiligen Netzhaut es sich handelt. Besonders circadian bzw. melanopisch wirksam ist dabei Licht, das aus dem schräg oben vor dem Betrachter gelegenen Raumwinkelbereich stammt und dementsprechend auf einen unteren Anteil der beiden Netzhäute auftrifft, da hier die entsprechend wirksamen Rezeptoren gehäuft lokalisiert sind.

Wenn nun die Größe des Lichtaustrittsbereichs 4 verstellt werden kann, lässt sich auf diese Weise auch die Größe eines beleuchteten Bereichs verändern und auf diese Weise - bei ansonsten konstant gehaltenen Bedingungen - besonders effektiv Einfluss auf die melanopische Wirkung nehmen. Vorzugsweise ist die Leuchte dabei so gestaltet, dass die Größe des Lichtaustrittsbereichs 4 wenigstens um einen Faktor 2 veränderbar ist, insbesondere wenigstens um einen Faktor 4, besonders bevorzugt wenigstens um einen Faktor 10.

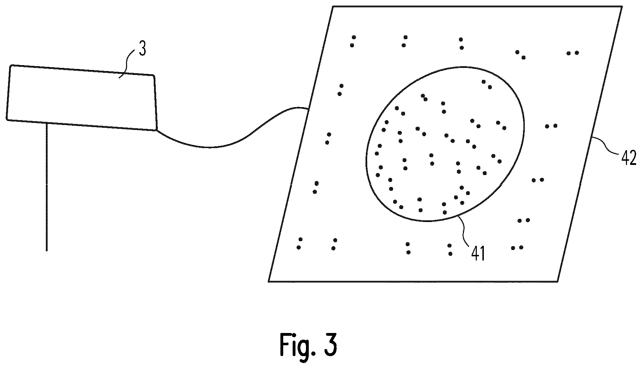

In Fig. 3 ist - wiederum nur sehr schematisch - die erste Größe 41 der Lichtaustrittfläche und die zweite Größe 42 der Lichtaustrittsfläche 4 angedeutet gezeigt. Bevorzugt kann die Steuereinheit 3 auch zur Veränderung der Größe der Lichtaustrittsfläche 4 gestaltet sein.

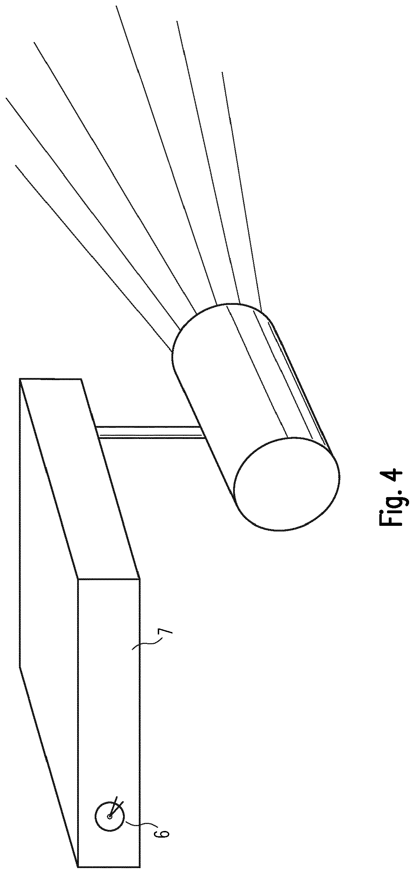

In Fig. 4 ist eine Ausführung der Leuchte skizziert, bei der ein Drehschalter 6 an einem Gehäuse 7 der Leuchte angeordnet ist, mit dem der melanopische bzw. circadiane Wirkungsfaktor der Leuchte verstellt werden kann. Vorzugsweise lässt sich mit dem Drehschalter 6 ein Potentiometer verstellen, das als Bestandteil der Steuereinheit 3 zur Ansteuerung der beiden Lichtquellen 1, 2 dient.

Die Leuchte kann beispielsweise als Downlight gestaltet sein oder als Flächenleuchte oder als eine Kombination hieraus.

Mit der Leuchte lassen sich also zwei Komponenten realisieren, die zur Veränderung der melanopischen bzw. circadianen Wirkung des Lichts dienen: zum einen über die Veränderung der spektralen Verteilung des von der Leuchte insgesamt abgegebenen Lichts und zum anderen über die Größe des Lichtaustrittsbereichs 4. Die melanopische bzw. circadiane Wirkung der Leuchte kann also eingestellt werden und gegebenenfalls auch in Abhängigkeit von unterschiedlichen Parametern angesteuert werden, wie zum Beispiel Tageszeit, Jahreszeit; dies ist auch individuell möglich, da keine Verschiebung der Farbtemperatur notwendig ist.

## Patentansprüche

1. Leuchte aufweisend
- eine erste Lichtquelle (1) zur Erzeugung eines ersten Lichts mit einer ersten Spektralverteilung (*S₁(λ)*), wobei das erste Licht durch einen ersten Farbort (*F1*) in einem Farbdiagramm repräsentiert ist,
- eine zweite Lichtquelle (2) zur Erzeugung eines zweiten Lichts mit einer zweiten Spektralverteilung (*S₂(λ)*), wobei das zweite Licht durch einen zweiten Farbort (*F2*) in dem Farbdiagramm repräsentiert ist,
wobei sich die zweite Spektralverteilung (*S₂(λ)*) von der ersten Spektralverteilung (*S₁(λ)*) unterscheidet,
- eine Steuereinheit (3) zur Ansteuerung der ersten Lichtquelle (1) und der zweiten Lichtquelle (2), die derart gestaltet ist, dass eine Intensität des ersten Lichts unabhängig von einer Intensität des zweiten Lichts verändert werden kann,
wobei die Leuchte derart gestaltet ist, dass der erste Farbort (*F1)* im Wesentlichen mit dem zweiten Farbort (*F2)* übereinstimmt,
**dadurch gekennzeichnet,**
**dass** der erste Farbort (*F1*) und der zweite Farbort (*F2*) innerhalb einer Sieben-Schritt-MacAdam-Ellipse lokalisiert sind,
wobei die Steuereinheit (3) dazu ausgelegt ist, die Intensität des ersten Lichts zu reduzieren und gleichzeitig die Intensität des zweiten Lichts zu erhöhen, um die melanopische Wirkung des von der Leuchte abgegebenen Lichts zu verändern, ohne dass sich hierbei der Farbeindruck und die Intensität des insgesamt von der Leuchte abgegebenen Lichts verändert.

2. Leuchte nach Anspruch 1,
bei der der erste Farbort (*F1*) und der zweite Farbort (*F2*) innerhalb einer Drei-Schritt-MacAdam-Ellipse lokalisiert sind.

3. Leuchte nach Anspruch 1 oder 2,
bei der der erste Farbort (*F1*) einer ersten Farbtemperatur (*CCT₁)* entspricht und der zweite Farbort (*F2*) einer zweiten Farbtemperatur (*CCT₂),* wobei sich die erste Farbtemperatur (*CCT₁)* um weniger als 500 K von der der zweiten Farbtemperatur (*CCT₂)* unterscheidet, vorzugsweise um weniger als 300 K, besonders bevorzugt um weniger als 100 K.

4. Leuchte nach Anspruch 3,
bei der die erste Farbtemperatur (*CCT₁)* und die zweite Farbtemperatur (*CCT₂*) zwischen 2000 K und 7000 K betragen, vorzugsweise zwischen 3000 K und 6000 K.

5. Leuchte nach einem der vorhergehenden Ansprüche,
die derart gestaltet ist, dass das erste Licht einen ersten circadianen Wirkungsfaktor (*A_{cν1}*) aufweist und das zweite Licht einen zweiten circadianen Wirkungsfaktor (*A_{cν2}*), derart, dass sich der erste circadiane Wirkungsfaktor (*A_{cν1}*) von dem zweiten circadianen Wirkungsfaktor (*A*_{*cν*2}) um mehr als 0,10, vorzugsweise um mehr als 0,20, besonders bevorzugt um mehr als 0,30 unterscheidet.

6. Leuchte nach einem der vorhergehenden Ansprüche,
bei der die erste Lichtquelle (1) eine erste LED-Lichtquelle ist und die zweite Lichtquelle (2) eine zweite LED-Lichtquelle ist.

7. Leuchte nach einem der vorhergehenden Ansprüche,
bei der die erste Lichtquelle (1) wenigstens eine LED zur Erzeugung eines roten Lichts und wenigstens eine LED zur Erzeugung eines weißen Lichts umfasst.

8. Leuchte nach einem der vorhergehenden Ansprüche,
bei der das erste Licht einen höheren Farbwiedergabeindex aufweist als das zweite Licht.

9. Leuchte nach einem der vorhergehenden Ansprüche,
weiterhin aufweisend
- einen Lichtaustrittsbereich (4) zum Durchtritt des ersten Lichts und des zweiten Lichts.

10. Leuchte nach Anspruch 9,
die derart gestaltet ist, dass eine Größe des Lichtaustrittsbereichs (4) veränderbar ist.

11. Leuchte nach Anspruch 10,
bei der die Größe des Lichtaustrittsbereichs (4) wenigstens um einen Faktor 2 veränderbar ist, vorzugsweise wenigstens um einen Faktor 4, besonders bevorzugt wenigstens um einen Faktor 10.

## Claims

1. Luminaire comprising
- a first light source (1) for generating a first light with a first spectral distribution (*S₁*(*λ*)), wherein the first light is represented by a first color locus (*F1*) in a color diagram,
- a second light source (2) for generating a second light with a second spectral distribution (*S₂*(*λ*)), wherein the second light is represented by a second color locus (*F2*) in the color diagram,
wherein the second spectral distribution (*S₂*(*λ*)) is different from the first spectral distribution (*S₁(λ*)),
- a control unit (3) for controlling the first light source (1) and the second light source (2), which is designed such that an intensity of the first light can be changed independently of an intensity of the second light,
wherein the luminaire is designed such that the first color locus (*F1*) substantially corresponds to the second color locus (*F2*),
**characterized in that**
the first color locus (*F1*) and the second color locus (*F2*) are located within a seven-step MacAdam ellipse,
wherein the control unit (3) is designed to reduce the intensity of the first light and at the same time to increase the intensity of the second light in order to change the melanopic effect of the light emitted by the luminaire without the color impression and the intensity of the light emitted by the luminaire overall changing.

2. Luminaire according to claim 1,
wherein the first color locus (*F1*) and the second color locus (*F2*) are located within a three-step MacAdam ellipse.

3. Luminaire according to claim 1 or 2,
wherein the first color locus (*F1*) corresponds to a first color temperature (*CCT₁*) and the second color locus (*F2*) corresponds to a second color temperature (*CCT₂*)*,* wherein the first color temperature (*CCT₁*) differs from the second color temperature (*CCT₂*) by less than 500 K, preferably less than 300 K, particularly preferably less than 100 K.

4. Luminaire according to claim 3,
wherein the first color temperature (*CCT₁*) and the second color temperature (*CCT₂*) are between 2000 K and 7000 K, preferably between 3000 K and 6000 K.

5. Luminaire according to any one of the preceding claims,
which is configured such that the first light has a first circadian action factor (*A_{cv1}*) and the second light has a second circadian action factor (A*_{cv2}*) such that the first circadian action factor (A*_{cv1}*) differs from the second circadian action factor (A*_{cv2}*) by more than 0.10, preferably more than 0.20, particularly preferably more than 0.30.

6. Luminaire according to any one of the preceding claims,
wherein the first light source (1) is a first LED light source and the second light source (2) is a second LED light source.

7. Luminaire according to any one of the preceding claims,
wherein the first light source (1) comprises at least one LED for generating a red light and at least one LED for generating a white light.

8. Luminaire according to any one of the preceding claims,
wherein the first light has a higher color rendering index than the second light.

9. Luminaire according to any one of the preceding claims,
further comprising
- a light exit region (4) for the passage of the first light and the second light.

10. Luminaire according to claim 9,
which is designed such that a size of the light exit region (4) can be changed.

11. Luminaire according to claim 10,
where the size of the light exit region (4) can be changed at least by a factor 2, preferably at least by a factor 4, particularly preferably at least by a factor 10.

## Revendications

1. Luminaire comportant
- une première source lumineuse (1) destinée à générer une première lumière ayant une première distribution spectrale *(S₁(λ)),* la première lumière étant représentée par une première localisation chromatique *(F1)* dans un diagramme chromatique,
- une seconde source lumineuse (2) destinée à générer une seconde lumière ayant une seconde distribution spectrale *(S₂(λ))*, la seconde lumière étant représentée par une seconde localisation chromatique *(F2)* dans un diagramme chromatique,
la seconde distribution spectrale *(S₂(λ))* étant différente de la première distribution spectrale *(S₁(λ)),*
- une unité de commande (3) destinée à commander la première source lumineuse (1) et la seconde source lumineuse (2), laquelle unité de commande est conçue de façon à pouvoir modifier une intensité de la première lumière en fonction d'une intensité de la seconde lumière,
le luminaire étant configuré de telle sorte que la première localisation chromatique *(F1)* coïncide sensiblement avec la seconde localisation chromatique *(F2),*
**caractérisé en ce**
**que** la première localisation chromatique *(F1)* et la seconde localisation chromatique *(F2)* sont situées à l'intérieur d'une ellipse MacAdam à sept étapes,
l'unité de commande (3) étant conçue pour réduire l'intensité de la première lumière et augmenter simultanément l'intensité de la seconde lumière afin de modifier l'effet mélanopique de la lumière émise par le luminaire sans que la perception des couleurs et l'intensité de toute la lumière émise par le luminaire soient modifiées.

2. Luminaire selon la revendication 1,
dans lequel la première localisation chromatique *(F1)* et la seconde localisation chromatique *(F2)* sont situées à l'intérieur d'une ellipse MacAdam à trois étapes.

3. Luminaire selon la revendication 1 ou 2,
dans lequel la première localisation chromatique *(F1)* correspond à une première température de couleur *(CCT₁)* et la seconde localisation chromatique *(F2)* correspond à une seconde température de couleur *(CCT₂),* la première température de couleur *(CCT₁)* étant différente de la seconde température de couleur *(CCT₂)* de moins de 500 K, de préférence de moins de 300 K, de manière particulièrement préférée de moins de 100 K.

4. Luminaire selon la revendication 3,
dans lequel la première température de couleur *(CCT₁)* et la seconde température de couleur *(CCT₂)* est comprise entre 2 000 et 7 000 K, de préférence entre 3 000 et 6 000 K.

5. Luminaire selon l'une quelconque des revendications précédentes,
configuré de telle sorte que la première lumière présente un premier facteur d'efficacité (*A_{cv1}*) circadien et la seconde lumière présente un second facteur d'efficacité (*A_{cv2}*) circadien de manière à ce que le premier facteur d'efficacité (*A_{cv1}*) circadien soit différent du second facteur d'efficacité (*A_{cv2}*) de plus de 0,10, de préférence de plus de 0,20, de manière particulièrement préférée de plus de 0,30.

6. Luminaire selon l'une quelconque des revendications précédentes,
dans lequel la première source lumineuse (1) est une première source lumineuse LED et la seconde source lumineuse (2) est une seconde source lumineuse LED.

7. Luminaire selon l'une quelconque des revendications précédentes,
dans lequel la première source lumineuse (1) comprend au moins une LED destinée à générer une lumière rouge et au moins une LED destinée à générer une lumière blanche.

8. Luminaire selon l'une quelconque des revendications précédentes,
dans lequel la première source lumineuse présente un indice de rendu des couleurs plus élevé que celui de la seconde lumière.

9. Luminaire selon l'une quelconque des revendications précédentes,
comprenant en outre
- une région de sortie de la lumière (4) pour le passage de la première lumière et de la seconde lumière.

10. Luminaire selon la revendication 9,
configuré de telle sorte qu'une dimension de la région de sortie de la lumière (4) peut être modifiée.

11. Luminaire selon la revendication 10,
dans lequel la dimension de la région de sortie de la lumière (4) peut être modifiée au moins d'un facteur 2, de préférence au moins d'un facteur 4, de manière particulièrement préférée au moins d'un facteur 10.
